# EUROPEAN PATENT APPLICATION

(11) **EP 2 200 094 A2**
(43) Date of publication of application: **23.06.2010**
(21) Application number: 09171715.7
(22) Date of filing: 30.09.2009
(51) Int. Cl.: H01L 31/058, H01L 31/052

(54) **Photovoltaic-thermal hybrid apparatus and assembly method thereof**

(30) Priority: 22.12.2008 KR 20080131670
(71) Applicant: SAMSUNG ELECTRONICS CO., LTD., Suwon-si, Gyeonggi-do (KR)
(72) Inventor: Oh, Jae Hyuk, Gyeonggi-do (KR); Wu, Seong Je, Gyeonggi-do (KR); Han, Seong Joo, Gyeonggi-do (KR); Choi, See Young, Gyeonggi-do (KR)
(74) Representative: Grünecker, Kinkeldey, Stockmair & Schwanhäusser Anwaltssozietät

(57) **Abstract**

Disclosed herein is a photovoltaic-thermal hybrid apparatus (1). The photovoltaic-thermal hybrid apparatus includes a plurality of photovoltaic-thermal modules (10). Each photovoltaic-thermal module includes at least one condenser (20), a solar cell (30) disposed at at least one side of the condenser, a frame (70) to surround the condenser and the solar cell, and a channel part (50) disposed in the frame to cool the solar cell. The photovoltaic-thermal modules are arranged adjacent to one another, and the channel part (50) of each photovoltaic-thermal module is connected to the channel part (50) of at least one neighboring photovoltaic-thermal module.

## Description

### BACKGROUND

### 1. Field

The present invention relates to an apparatus using solar energy, and, more particularly, to a photovoltaic-thermal hybrid apparatus that is capable of generating electricity using solar energy and, at the same time, recovering solar heat that has not been converted into electricity.

### 2. Description of the Related Art

There have been developed a photovoltaic technology using a light of the sun using a module including solar cells, a solar thermal technology using a thermal property of the sun through a solar collector, and a hybrid technology using both the photo and thermal properties of the sun.

The photovoltaic technology using the light of the sun is a method using a principle in which, when solar light of a wavelength range having energy greater than a threshold energy of a semiconductor is incident upon a solar cell formed by the p-n junction of semiconductors, current flows in a load connected externally to the solar cell by a photoelectric effect. As needed, solar cells may be connected in series and/or in parallel.

The solar thermal technology using the thermal property of the sun is a method of receiving incident solar energy using a solar collector and recovering heat through a heat medium. The solar thermal technology has the most widespread use at the current time.

A solar energy utilization apparatus capable of simultaneously achieving power generation and heat collection using both the light and heat of the sun has been developed and used.

In an example of the solar energy utilization apparatus, several solar cells are put together into a module, and pipes to cool and recover heat collected by heat absorption plates mounted at the rears of the solar cells are disposed. To shorten the heat recovery pipes and effectively utilize the collected heat, the pipes are connected between the modules, and the pipes are connected to a storage tank.

A problem of the above-described solar energy utilization apparatus is that cooling pipes must be installed over the entire area along the heat absorption plates installed simultaneously with the solar cells. As a result, the cooling pipes are lengthened, and therefore, the installation period and the assembly costs increase.

Also, the entire panel is thickened by the installation of the cooling pipes, restricting the installation environment.

Also, it is necessary to connect the pipes disposed at the heat absorption plates of the respective modules by welding.

### SUMMARY

Therefore, it is an aspect of the present invention to provide a photovoltaic-thermal hybrid apparatus constructed in a structure to achieve photovoltaic power generation and solar heat recovery with a minimized thickness.

It is another aspect of the present invention to provide a photovoltaic-thermal hybrid apparatus constructed in a structure to exhibit high efficiency and, at the same time, reduce the manufacturing costs.

It is a further aspect of the present invention to provide a photovoltaic-thermal hybrid apparatus constructed in a simple assembly structure.

Additional aspects and/or advantages of the invention will be set forth in part in the description which follows and, in part, will be apparent from the description, or may be learned by practice of the invention.

The foregoing and/or other aspects of the present invention may be achieved by providing a photovoltaic-thermal hybrid apparatus including: a plurality of photovoltaic-thermal modules each including a condenser, a solar cell disposed at a first side of the condenser, a frame to surround the condenser and the solar cell, and a channel disposed in the frame to cool the solar cell, wherein the photovoltaic-thermal modules are arranged adjacent to one another, and the channel of each photovoltaic-thermal module is connected to the channel of a neighboring one of the photovoltaic-thermal modules.

The frame of each photovoltaic-thermal module may be connected to the frames of the neighboring photovoltaic-thermal modules.

The channel of each photovoltaic-thermal module may be directly connected to the channel of at least one neighboring photovoltaic-thermal module.

The photovoltaic-thermal hybrid apparatus may further include a connection member to connect the channel of each photovoltaic-thermal module to the channel of at least one neighboring photovoltaic-thermal module.

The connection member may include a quick connector to interconnect ends of the channel parts of the neighboring photovoltaic-thermal modules.

Each photovoltaic-thermal module may be formed in a rectangular shape, and each photovoltaic-thermal module may be provided at at least one corner of the frame thereof with a connection to interconnect the neighboring photovoltaic-thermal modules.

The connection includes at least one pair of connections disposed at opposite corners of each photovoltaic-thermal module.

The channel may have first and second openings formed at opposite ends thereof, and the first and second openings may be disposed at the connections, respectively.

The first and/or the second opening may be flexible.

The connection may include an opening and closing part to open and close the connection.

The opening and closing part may include an elastic member to provide an elastic force in a direction to close the connection.

The solar cell may include a pair of solar cells disposed at opposite sides of the condenser, and the channel may be disposed at rears of the solar cells in parallel with the solar cells such that the channel corresponds to the solar cells.

The at least one condenser may change a direction of some incident solar energy therein in a radial direction and emit some incident solar energy outside.

The at least one condenser may include a plurality of stacked condensers, and the condensers may transmit the solar energy to the neighboring condensers.

The photovoltaic-thermal hybrid apparatus may further include thermal diffusion layers disposed between the solar cells and the channel to transmit energy that has not been converted into electricity by the solar cells to the channel.

The photovoltaic-thermal hybrid apparatus may further include a heat insulation layer disposed in the frame, such that the heat insulation layer surrounds the solar cells and the channel, to prevent the discharge of heat.

The photovoltaic-thermal hybrid apparatus may further include a reflection plate disposed at another side of the condenser to reflect the solar energy to the solar cell.

The foregoing and/or other aspects of the present invention may be achieved by providing an assembly method of a photovoltaic-thermal hybrid apparatus, including: preparing a plurality of photovoltaic-thermal modules, each of the photovoltaic-thermal modules including at least one condenser, a solar cell disposed at a side of the condenser, a frame to surround the condenser and the solar cell, and a channel disposed in the frame to cool the solar cell; arranging the photovoltaic-thermal modules adjacent to one another; and connecting at least one pair of channel parts of the photovoltaic-thermal modules arranged adjacent to one another to form a cooling channel.

The condenser may change a direction of some incident solar energy therein in a radial direction and guide the direction-changed solar energy to the side thereof.

The assembly method may further include preparing a connection member to interconnect the channel parts, and the connecting the at least one pair of channel parts may include connecting ends of the at least one pair of channel parts using the connection member.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a perspective view schematically illustrating a photovoltaic-thermal hybrid apparatus according to an embodiment of the present invention;
FIG. 2 is a sectional view taken along line A-A' of FIG. 1;
FIG. 3 is a sectional view taken along line B-B' of FIG. 1;
FIG. 4 is a sectional view schematically illustrating the operation of the photovoltaic-thermal hybrid apparatus of FIG. 1;
FIG. 5 is an assembly view illustrating the assembly of the photovoltaic-thermal hybrid apparatus of FIG. 1;
FIG. 6 is a perspective view illustrating an assembled part of the photovoltaic-thermal hybrid apparatus of FIG. 1;
FIG. 7 is an assembly view illustrating the assembly of a modification of the photovoltaic-thermal hybrid apparatus of FIG. 1;
FIG. 8 is a sectional view schematically illustrating a photovoltaic-thermal hybrid apparatus according to another embodiment of the present invention;
FIG. 9 is a sectional view illustrating a photovoltaic-thermal module included in the photovoltaic-thermal hybrid apparatus of FIG. 8;
FIG. 10 is a sectional view schematically illustrating a photovoltaic-thermal hybrid apparatus according to a further embodiment of the present invention; and
FIG. 11 is a plan view, in section, illustrating a photovoltaic-thermal module included in the photovoltaic-thermal hybrid apparatus of FIG. 10.

### DETAILED DESCRIPTION OF EMBODIMENTS

Reference will now be made in detail to the embodiments of the present invention, examples of which are illustrated in the accompanying drawings, wherein like reference numerals refer to the like elements throughout. The embodiments are described below to explain the present invention by referring to the figures.

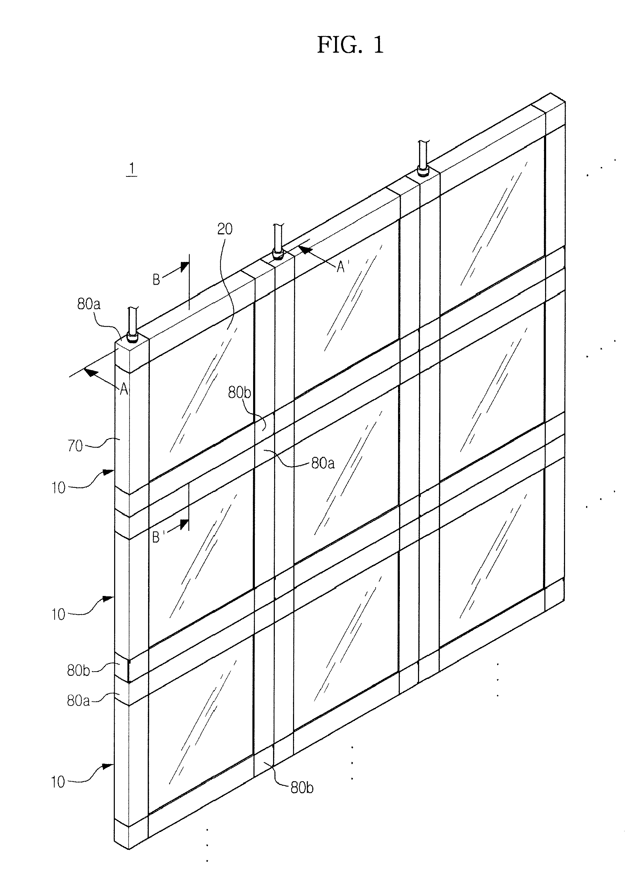

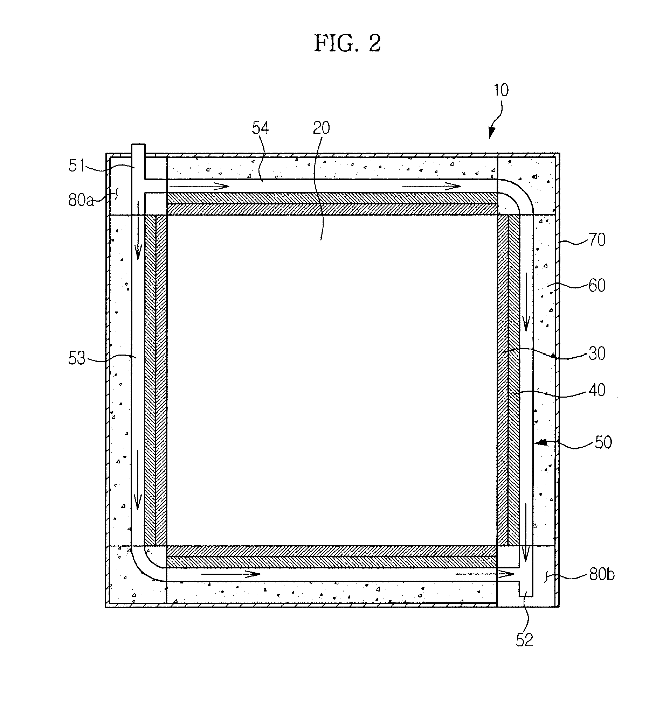

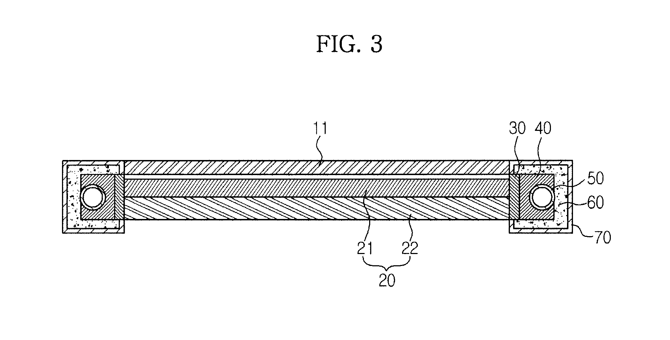

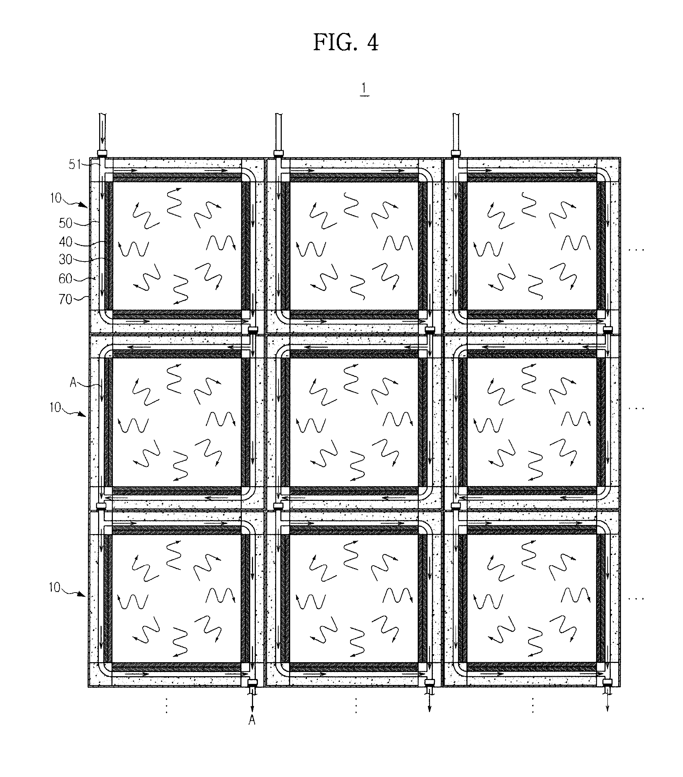

FIG. 1 is a perspective view schematically illustrating a photovoltaic-thermal hybrid apparatus 1 according to an embodiment of the present invention, FIG. 2 is a sectional view taken along line A-A' of FIG. 1, and FIG. 3 is a sectional view taken along line B-B' of FIG. 1. Also, FIG. 4 is a sectional view schematically illustrating the operation of the photovoltaic-thermal hybrid apparatus of FIG. 1.

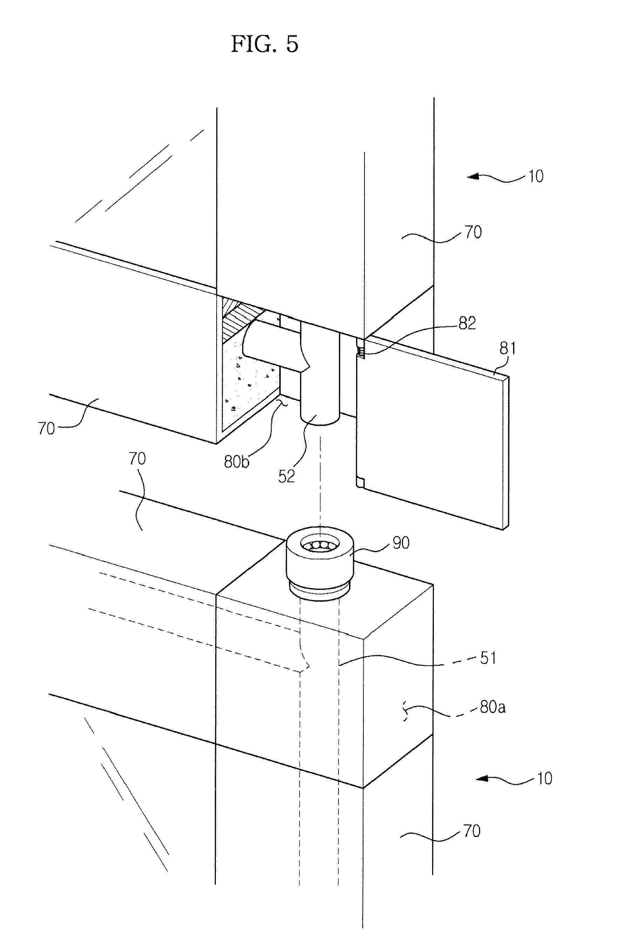

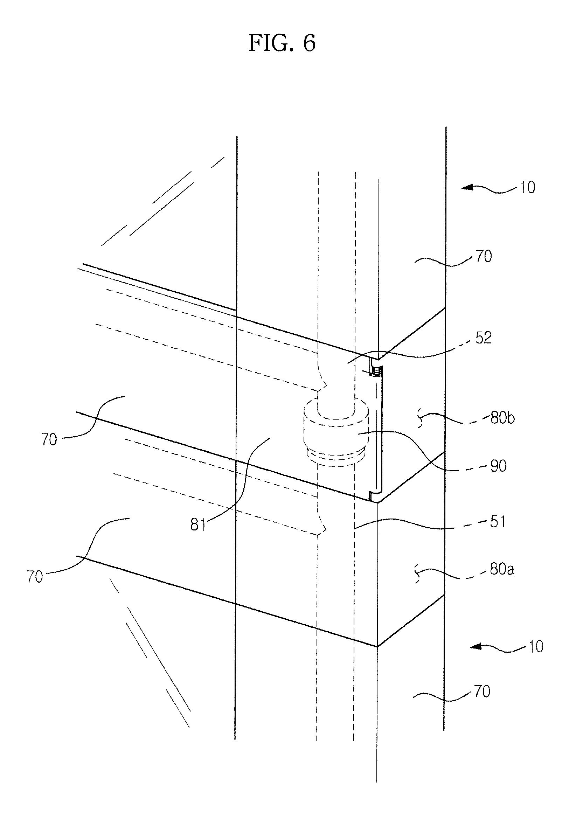

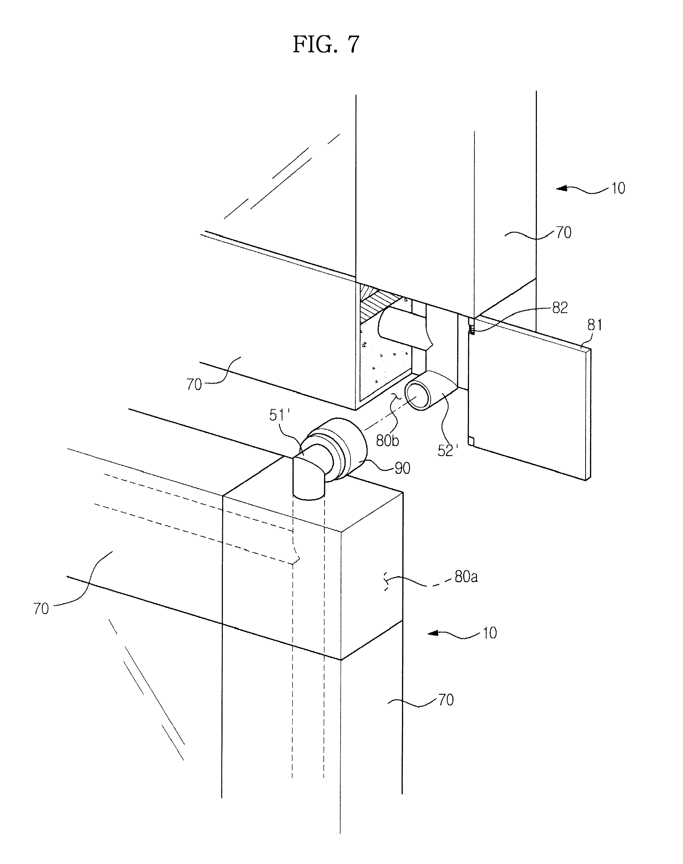

FIG. 5 is an assembly view illustrating the assembly of the photovoltaic-thermal hybrid apparatus of FIG. 1, FIG. 6 is a perspective view illustrating an assembled part of the photovoltaic-thermal hybrid apparatus of FIG. 1, and FIG. 7 is an assembly view illustrating the assembly of a modification of the photovoltaic-thermal hybrid apparatus of FIG. 1.

As shown in FIGS. 1 to 3, the photovoltaic-thermal hybrid apparatus 1 is constructed in a structure in which a plurality of unit-cell type photovoltaic-thermal modules 10, each having a channel part 50 at the edge thereof, are disposed adjacent to one another, and the channel part 50 of each photovoltaic-thermal module 10 is connected to the channel part 50 of at least one neighboring photovoltaic-thermal module 10 to form a cooling channel A (See FIG. 4).

As shown in FIGS. 2 to 4, each photovoltaic-thermal module 10 is formed approximately of a rectangular panel.

Each photovoltaic-thermal module 10 may include a condenser 20 to absorb incident solar energy and radially emit the solar energy therein, solar cells 30 installed at the edges of the condenser 20 such that the solar cells 30 cover the respective edges of the condenser 20, thermal diffusion layers 40 to absorb energy that has not been converted into electricity by the solar cells 30, the channel part 50 disposed at the rears of the thermal diffusion layers 40 to cool the solar cells 30 and recover solar heat, a heat insulation layer 60 to prevent heat in the thermal diffusion layers 40 and the channel part 50 from being discharged to the outside, and a frame 70 to surround the condenser 20, the frame 70 having a space to receive the solar cells 30, the thermal diffusion layers 40, and the channel part 50 defined therein.

Also, connections 80 (80a and 80b) to connect the channel parts 50 of the neighboring photovoltaic-thermal modules 10 are provided at at least one pair of opposite corners of the frame 70.

Above the condenser 20, as shown in FIG. 3, may be provided a transmission layer 11 made of plate glass or a transparent material exhibiting high transmissivity of solar energy.

In this embodiment, the condenser 20 is implemented by a plurality of stacked panels although the condenser 20 may be implemented by a single flat panel.

The condenser 20 is constructed in a structure to absorb solar energy, to change the direction of some of the solar energy such that some of the solar energy radially moves in the condenser 20, and to transmit the remaining solar energy.

An example of the condenser 20 is disclosed in U.S. Patent Application Publication No. 2005-290625, the disclosure of which is substituted for the detailed structure of the condenser 20.

The condenser 20 may include a first condenser 21 disposed adjacent to the transmission layer 11 in parallel to the transmission layer 11 to absorb solar energy incident through the transmission layer 11, to change the direction of some of the solar energy such that some of the solar energy radially moves therein, and to transmit the remaining solar energy. The condenser 20 also includes a second condenser 22 disposed at the bottom of the first condenser 21 to absorb the solar energy transmitted through the first condenser 21, to change the direction of some of the solar energy such that some of the solar energy radially moves therein, and to transmit the remaining solar energy.

Although not shown, a third condenser may be disposed at the bottom of the second condenser in the same manner. Also, a fourth condenser may be disposed at the bottom of the third condenser in the same manner.

The condenser may be implemented by a plurality of stacked condensers, the number of which is not limited to 2 to 4.

In this embodiment, the condenser 20 is formed in the shape of a rectangular panel although the condenser 20 may be formed in the shape of a polygon or other different shapes.

In this embodiment, the transmission layer 11 and the first condenser 21 may be in contact with each other or spaced apart from each other by several micrometers to dozens of centimeters.

Each solar cell 30 converts solar energy into electric energy. Each solar cell 30 generates electricity using a p-type semiconductor and an n-type semiconductor. That is, when light is illuminated on each solar cell, electrons and holes are generated in each solar cell. The generated charges move to P and N poles, by which potential difference is created between the P and N poles. At this time, when a load is connected to the solar energy, electric current flows in the load.

Each solar cell 30, having a size corresponding to each side of the condenser 20, is fixed to each side of the condenser 20. Since the condenser 20 is formed in the shape of a thin plate, each solar cell 30 corresponding to each side of the condenser 20 may be formed in the shape of a long bar.

Each thermal diffusion layer 40 is made of a material exhibiting high heat conductivity. Each thermal diffusion layer 40 is mounted to the rear of the corresponding solar cell 30 to absorb solar energy that has not been converted into electricity by the corresponding solar cell 30 and to transmit the absorbed solar energy to the channel part 50.

The channel part 50 is disposed at the rears of the thermal diffusion layers 40 such that the channel part 50 surrounds the thermal diffusion layers 40.

The solar energy transmitted from the solar cells through the thermal diffusion layers 40 is heat-exchanged with a cooling fluid flowing along the channel part 50. As a result, the cooling fluid recovers the solar heat that has not been converted into electric energy.

Opposite ends of the channel part 50 are provided at the connections 80. A pair of openings 51 and 52 are formed at the opposite ends of the channel part 50. The openings 51 and 52 may be an introduction port through which a fluid is introduced and a discharge port through which the fluid is discharged. In this embodiment, the first opening 51 provided at the upper connection 80a of each photovoltaic-thermal module 10 is referred to as an introduction port, and the second opening 52 provided at the lower connection 80b of each photovoltaic-thermal module 10 is referred to as a discharge port, for the sake of convenience.

At the first and second openings 51 and 52, sub channel parts diverge from the channel part 50 such that the sub channel parts surround the corresponding solar cells 30. The channel part 50 may include a first channel part 53 diverging downward from the first opening 51 and a second channel part 54 diverging from the first opening 51 in the horizontal direction, on the drawing.

The first and second channel parts 53 and 54 are joined to each other at the lower connection 80b, and the joined first and second channel parts 53 and 54 are connected to the second opening 52, through which a fluid is discharged.

In this embodiment, the first and second channel parts 53 and 54 are formed in the sectional shape of a circle although the first and second channel parts 53 and 54 may be formed in various sectional shapes, such as a triangle, a rectangle, a polygon, and an ellipse.

Also, the first opening 51 and/or the second opening 52 is made of a flexible material or constructed in a flexible structure such that the first opening 51 and/or the second opening 52 move flexibly.

The heat insulation layer 60 fixes the thermal diffusion layers 40 and the channel part 50. The heat insulation layer 60 surrounds the thermal diffusion layers 40 and the channel part 50 to prevent heat in the thermal diffusion layers 40 and the cooling channel A from being discharged to the outside, thereby improving efficiency.

The frame 70 is disposed outside the heat insulation layer 60 to integrate each photovoltaic-thermal module 10 into a unit cell.

As shown in FIG. 5, the lower connection 80b includes an opening and closing part 81 to open and close the lower connection 80b. At a hinge shaft of the opening and closing part 81 is provided an elastic member 82 to provide an elastic force in the direction for the opening and closing part 81 to close the lower connection 80b.

During the assembly of the photovoltaic-thermal modules 10, the opening and closing part 81 of each photovoltaic-thermal module 10 is opened, and the channel part 50 of the neighboring photovoltaic-thermal module 10 is assembled. Consequently, it is possible to secure a visual field of an assembly person during the assembly of the photovoltaic-thermal modules 10, thereby achieving each connection between the channel parts 50 of the respective photovoltaic-thermal modules 10.

In this embodiment, the connections 80 are constructed in a hollow structure although heat insulation layers may be formed in the connections 80.

A connection member 90 as shown in FIG. 6 is provided to interconnect the channel parts 50 of the neighboring photovoltaic-thermal modules 10.

The channel parts 50 of the neighboring photovoltaic-thermal modules 10 may be directly coupled to each other. In this embodiment, however, the second opening 52 of the upper photovoltaic-thermal module 10 and the first opening 51 of the lower photovoltaic-thermal module 10 communicate with each other via the connection member 90.

The connection member 90 may be implemented, for example, by a one-touch type quick connector. Of course, various types of connection members, such as a flange type connector and a screw type connector, may be used.

A plurality of the photovoltaic-thermal modules are integrated to form a photovoltaic-thermal hybrid apparatus.

In the modification of FIG. 7, a second opening 52' is bent forward, and, correspondingly, a first opening 51' is bent rearward, unlike the coupling structure between the first and second openings as described above.

Consequently, the connection member 90 is fitted onto the first opening 51', the lower photovoltaic-thermal module 10 is moved rearward, or the upper photovoltaic-thermal module 10 is moved frontward, and the second opening 52' of the upper photovoltaic-thermal module 10 is inserted into the connection member.

At this time, the assembly person may bend the first and second openings 51' and 52' to couple the first and second openings 51' and 52' since the first and second openings 51' and 52' are made of a flexible material. Alternatively, the first and second openings 51' and 52' may be manufactured in a bend structure, and the assembly may be performed using the bent first and second openings 51' and 52'.

Hereinafter, an assembly method of the photovoltaic-thermal hybrid apparatus with the above-stated construction will be described with reference to FIGS. 4 to 6.

First, a plurality of photovoltaic-thermal modules 10 are disposed adjacent to one another.

In this embodiment, "the photovoltaic-thermal modules 10 are disposed adjacent to one another" means that the photovoltaic-thermal modules 10 are disposed in contact with one another or that the photovoltaic-thermal modules 10 are disposed while being spaced apart from one another by a predetermined distance.

Subsequently, the opening and closing part 81 of the lower connection 80b provided at the lower corner of an upper one of the photovoltaic-thermal modules 10, disposed adjacent to one another, is opened frontward to expose the second opening 52 of the upper photovoltaic-thermal module 10 outside.

Subsequently, the upper connection 80a of a lower photovoltaic-thermal module 10 is disposed adjacent to the lower connection 80b of the upper photovoltaic-thermal module 10. Subsequently, one end of the second opening 52 is inserted into the connection member 90, coupled to one end of the first opening 51, such that the first and second openings 51 and 52 communicate with each other.

When the lower photovoltaic-thermal module 10 and the upper photovoltaic-thermal module 10 are coupled to each other as described above, easy and convenient coupling between the two photovoltaic-thermal modules 10 is achieved without interference therebetween.

At this time, it is possible for the assembly person to modify the first and second openings 51 and 52 into an easy coupling structure, since the first and second openings 51 and 52 are made of a flexible material or constructed in a flexible structure, thereby improving workability.

When an external force is removed after the coupling, as shown in FIG. 6, the opening and closing part 81 closes the front of the lower connection 80b by a restoring force of the elastic member 82, whereby the assembly of the photovoltaic-thermal modules is completed.

Other photovoltaic-thermal modules 10 are sequentially disposed below the lower photovoltaic-thermal module 10, and the first and second openings 51 and 52 of the respective photovoltaic-thermal modules 10 are connected as described above to assemble the photovoltaic-thermal modules 10 in the vertical direction.

In the same manner, a new photovoltaic-thermal module 10 is disposed adjacent to the upper photovoltaic-thermal module 10 in the horizontal direction. Subsequently, other photovoltaic-thermal modules 10 are sequentially disposed below the new photovoltaic-thermal module 10, and the first and second openings 51 and 52 of the respective photovoltaic-thermal modules 10 are connected as described above to assemble the photovoltaic-thermal modules 10 in the horizontal direction.

Consequently, the photovoltaic-thermal modules 10 included in this embodiment are assembled in the vertical direction and in the horizontal direction to provide a photovoltaic-thermal hybrid apparatus having a required size.

In the photovoltaic-thermal hybrid apparatus 1, the channel part 50 of each photovoltaic-thermal module 10 communicates with the channel parts 50 of the neighboring photovoltaic-thermal modules 10 to form the cooling channel A.

In this embodiment, the photovoltaic-thermal modules 10 are disposed adjacent to each other in the vertical direction, and the channel parts 50 of the neighboring photovoltaic-thermal modules 10 are connected to each other, although the photovoltaic-thermal modules 10 may be disposed adjacent to each other in the horizontal direction, and the channel parts 50 of the neighboring photovoltaic-thermal modules 10 may be connected to each other.

Also, in this embodiment, the photovoltaic-thermal modules 10 are disposed three by three not only in the vertical direction but also in the horizontal direction, although the photovoltaic-thermal hybrid apparatus may be constituted by two or more photovoltaic-thermal modules 10. Alternatively, it is possible to construct the photovoltaic-thermal hybrid apparatus using various other numbers of the photovoltaic-thermal modules based on the location and shape of an installation space.

A cooling fluid flowing along the cooling channel cools the solar cells and, at the same time, absorbs and recovers solar heat.

Hereinafter, the operation of the photovoltaic-thermal hybrid apparatus according to this embodiment will be described.

In the photovoltaic-thermal hybrid apparatus 1, as shown in FIGS. 3 and 4, solar energy incident upon the transmission layer 11 reaches the first condenser 21. Some of the solar energy radially moves in the first condenser 21. The remaining solar energy passes through the first condenser 21 and is incident upon the second condenser 22. Some of the solar energy incident upon the second condenser 22 radially moves in the second condenser 22. That is, the solar energy incident upon the first and second condensers 21 and 22 radially moves toward the edges of the first and second condensers 21 and 22 by a material constituting the first and second condensers 21 and 22. The solar energy guided to the edges of the condenser 20 is converted into electricity by the solar cells 30.

Solar energy incident upon the transmission layer 11 having a large area is accumulatively transmitted to the solar cells 30 disposed at the respective sides of the thin condenser 20, and therefore, condensing efficiency is improved.

At this time, when a cooling fluid is introduced through the first opening 51 of the upper photovoltaic-thermal module 10 of the photovoltaic-thermal hybrid apparatus 1, the cooling fluid flows along the cooling channel A formed by the communication between the channel parts 50 of the respective photovoltaic-thermal modules 10.

The cooling fluid in the cooling channel A absorbs and recovers the solar heat that has not been converted into electricity by the solar cells 30 through the thermal diffusion layers 40, exhibiting high heat conductivity, formed at the rears of the respective solar cells 30.

Although common tap water may be used as the cooling fluid, ionic water or other different fluids may be used to prevent pollution and improve durability. Also, gas, such as air, may be used. The cooling channel may be implemented by a heat pipe.

In the photovoltaic-thermal hybrid apparatus according to this embodiment, each thin photovoltaic-thermal module 10 is constructed by preparing a flat panel type condenser 20, disposing solar cells 30 and a cooling channel A at the edges of the condenser 20, and putting the condenser 20, the solar cells 30, and the cooling channel A in a frame 70, and a plurality of the photovoltaic-thermal modules are integrated by a simple assembly method.

Also, the photovoltaic-thermal hybrid apparatus according to this embodiment only requires a connection pipe (not shown) to connect the outermost photovoltaic-thermal module to a heat recovery apparatus (not shown), and therefore, it is not necessary to install additional pipes to supply and recover the cooling fluid to each photovoltaic-thermal module, unlike the conventional art.

Not only solar cell power generation but also solar heat recovery is possible, thereby achieving high overall efficiency. Consequently, much energy acquisition at the same installation area is possible. Also, since the photovoltaic-thermal hybrid apparatus is manufactured in a very thin module type structure, it is possible to minimize the restrictions of the conventional design such as installation place and installation condition.

Also, each photovoltaic-thermal module is formed as a unit cell having a channel therein, and the end of each channel is configured to be easily coupled to the channel of the neighboring photovoltaic-thermal module. Consequently, the assembly costs are reduced, and the assembly time is shortened, as compared with the conventional photovoltaic-thermal hybrid apparatus.

Hereinafter, a photovoltaic-thermal hybrid apparatus according to another embodiment will be described.

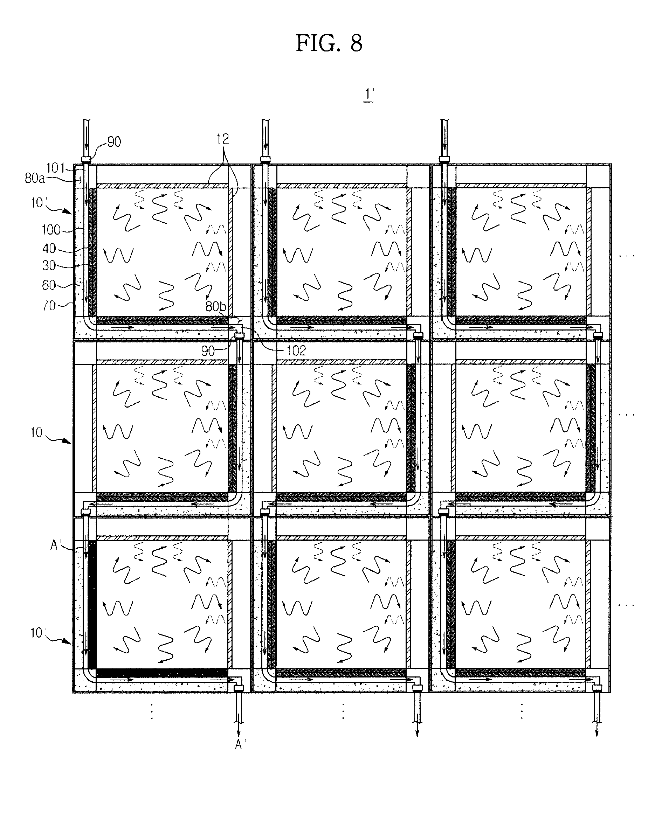

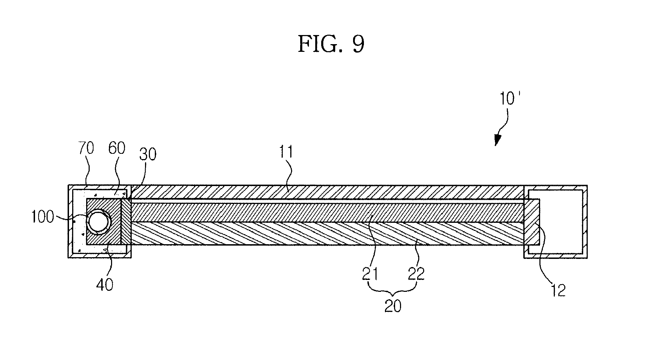

FIG. 8 is a sectional view schematically illustrating a photovoltaic-thermal hybrid apparatus 1' according to another embodiment, and FIG. 9 is a sectional view illustrating a photovoltaic-thermal module included in the photovoltaic-thermal hybrid apparatus of FIG. 8.

The photovoltaic-thermal hybrid apparatus according to this embodiment is identical in construction to the photovoltaic-thermal modules and assembly using the photovoltaic-thermal modules according to the previous embodiment, except that some solar cells mounted at the edges of a condenser are replaced by reflection plates, and thermal diffusion layers and a channel are omitted from the rears of the reflection plates.

The same elements of this embodiment as the previous embodiment are denoted by the same reference numerals, and a description thereof will not be given.

As shown in FIGS. 8 and 9, the photovoltaic-thermal hybrid apparatus 1' is constructed in a structure in which a plurality of unit-cell type photovoltaic-thermal modules 10', each having a channel 100 at one-side edge thereof, are disposed adjacent to one another, and the channel 100 of each photovoltaic-thermal module 10' is connected to the channel 100 of at least one neighboring photovoltaic-thermal module 10' to form a cooling channel A', in the same manner as the previous embodiment.

Each photovoltaic-thermal module 10' may include a condenser 20 to absorb incident solar energy and radially emit the solar energy therein, solar cells 30 installed at some edges of the condenser 20, reflectors 12 installed at the other edges of the condenser to reflect incident solar energy to the solar cells 30, and thermal diffusion layers 40 disposed at the rears of the solar cells 30 to absorb energy that has not been converted into electricity by the solar cells 30, the channel 100 disposed at the rears of the thermal diffusion layers 40 to cool the solar cells 30 and recover solar heat. The module 10' may also include a heat insulation layer 60 to prevent heat in the thermal diffusion layers 40 and the channel 100 from discharging outside, and a frame 70 to surround the condenser 20, the frame 70 having a space to receive the solar cells 30, the reflectors 12, the thermal diffusion layers 40, and the channel 100 defined therein.

Also, connections 80 to connect the channel parts 100 of the neighboring photovoltaic-thermal modules 10' are provided at at least one pair of opposite corners of the frame 70.

In this embodiment, the condenser 20 is formed of a rectangular panel, the solar cells 30 are disposed at the two neighboring edges of the condenser 20, and the reflectors 12 are disposed at the remaining neighboring edges of the condenser 20 opposite to the solar cells 30.

In this embodiment, no channel is defined at the rears of the reflectors 12, although thermal diffusion layers and a channel may be formed at the rears of the reflectors 12, in the same manner as in the solar cells, to absorb and recover heat from the reflectors.

Also, no coolant pipe is installed at the rears of the reflectors 12 since it is not necessary to recover heat, and therefore, the installation of the heat insulation layer may also be omitted.

Each thermal diffusion layer 40, having a size corresponding to each solar cell 30, is only mounted to the rear of the corresponding solar cell 30. The channel 100 is installed in contact with the thermal diffusion layers 40. A first opening 101 is formed at one end of the channel 100, and a second opening 102 is formed at the other end of the channel 100, such that a fluid flows along the channel 100 in one direction.

The channel 100 is located at positions corresponding to the rears of the solar cells. In this embodiment, the channel 100 extends downward from the first opening 101 and is bent in the horizontal direction, as shown in FIG. 8. At the first opening 101 is mounted a connection member 90 to connect the first opening 101 to the second opening 102 of the neighboring photovoltaic-thermal module 10'.

An assembly method of the photovoltaic-thermal hybrid apparatus according to this embodiment is identical to that according to the previous embodiment and the modification thereof.

Hereinafter, the operation of the photovoltaic-thermal hybrid apparatus according to this embodiment will be described.

Solar energy incident upon the transmission layer 11 reaches the first condenser 21. Some of the solar energy radially moves in the first condenser 21. The remaining solar energy passes through the first condenser 21 and is incident upon the second condenser 22. Some of the solar energy incident upon the second condenser 22 radially moves in the second condenser 22. That is, the solar energy incident upon the first and second condensers 21 and 22 radially moves toward the reflectors 12 disposed at the two neighboring edges of the first and second condensers 21 and 22 by a material constituting the first and second condensers 21 and 22. The solar energy, reaching the reflectors 12, is reflected to the solar cells 30 disposed at the remaining neighboring edges of the first and second condensers 21 and 22.

As a result, the solar energy incident upon the solar cells 30 is converted into electric energy.

At this time, when a cooling fluid is introduced through the first opening 51 of the upper photovoltaic-thermal module 10' of the photovoltaic-thermal hybrid apparatus 1', the cooling fluid flows along the cooling channel A' formed by the communication between the channel parts 100 of the respective photovoltaic-thermal modules 10'. Consequently, the remaining solar heat that has not been converted into electric energy by the solar cells 30 is recovered by the cooling fluid in the cooling channel A through the thermal diffusion layers 40.

In addition to the effect of the photovoltaic-thermal hybrid apparatus according to the previous embodiment, therefore, it is possible to increase a concentration ratio while reducing the installation area of the high-priced solar cells, thereby maintaining efficiency while reducing the costs. Also, it is not necessary to install the thermal diffusion layers, the cooling channel, and the heat insulation layer at the sides where the reflectors are installed, thereby improving convenience in manufacture and installation and reducing the manufacturing costs.

Hereinafter, a photovoltaic-thermal hybrid apparatus according to a further embodiment will be described.

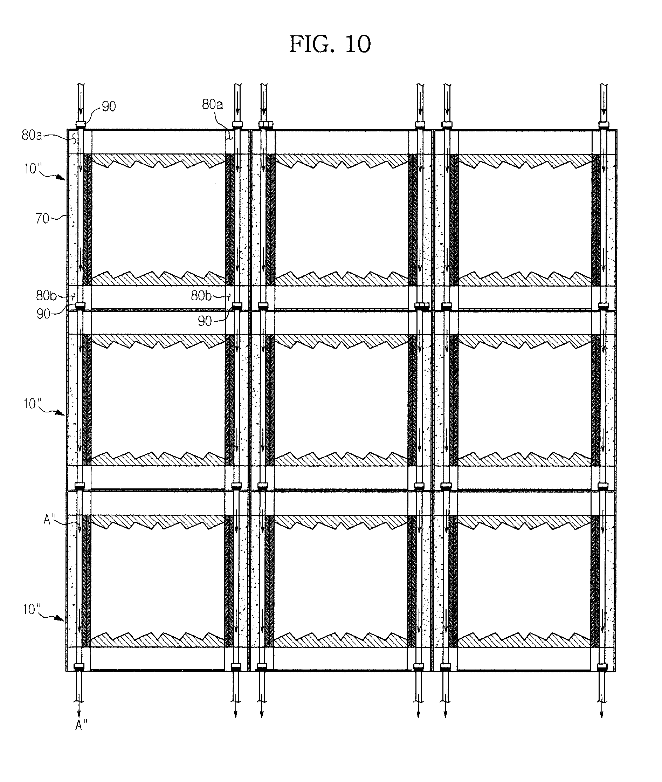

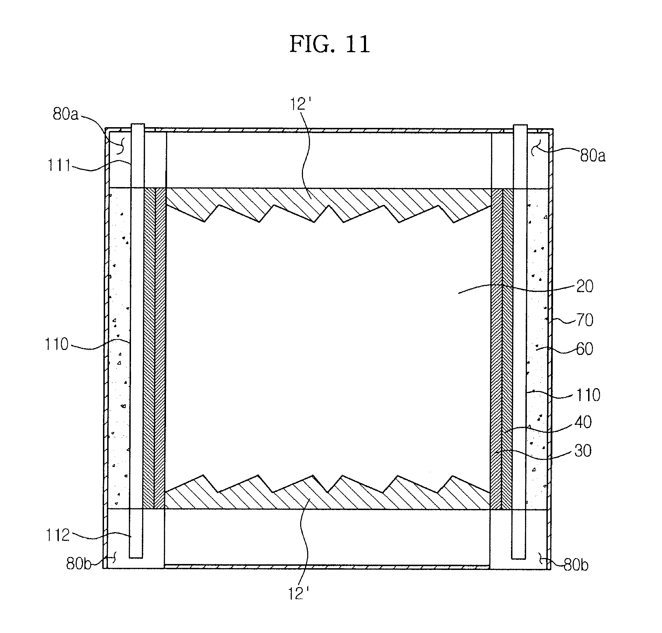

FIG. 10 is a sectional view schematically illustrating a photovoltaic-thermal hybrid apparatus according to a further embodiment of the present invention, and FIG. 11 is a plan view, in section, illustrating a photovoltaic-thermal module included in the photovoltaic-thermal hybrid apparatus of FIG. 10.

The photovoltaic-thermal hybrid apparatus according to this embodiment is identical in construction to that according to the previous embodiment except that there is a slight difference between these embodiments with respect to the installation positions of solar cells, the installation positions of thermal diffusion layers and a cooling channel, and the shape of reflectors in each photovoltaic-thermal module.

The same elements of this embodiment as the previous embodiment are denoted by the same reference numerals, and a description thereof will not be given.

As shown in FIGS. 10 and 11, a pair of reflectors 12' are disposed at two opposite edges of the condenser 20, and a pair of solar cells 30 are disposed at the other two opposite edges of the condenser 20.

Each reflector 12' may be formed in the sectional shape of symmetrical sawteeth. The sawteeth of the reflectors disposed at the top and bottom of the condenser may be arranged in opposite directions.

In this embodiment, the reflectors are formed in the sectional shape of the sawteeth although the reflectors may be formed in various shapes to transmit solar energy toward the solar cells opposite thereto.

In the same manner as the previous embodiment, thermal diffusion layers 40 and channel parts 110 may be disposed at the rears of the solar cells 30 such that the thermal diffusion layers 40 and the channel parts 110 are thermally insulated by heat insulation layers 60, and the installation of thermal diffusion layers, channel parts, and heat insulation layers at the rears of the reflectors 12' may be omitted.

Consequently, solar energy incident upon the reflectors 12' is reflected and guided to the other two opposite edges of the condenser 20, where the solar energy is converted into electricity by the solar cells 30, and solar heat is recovered by the thermal diffusion layers 40 and the channel parts 110 disposed at the rears of the solar cells 30.

In this embodiment, each reflector 12' is constructed in a symmetrical structure, with the result that the left parts of the upper and lower reflectors 12' reflect and transmit solar energy to the left solar cell 30 side, and the right parts of the upper and lower reflectors 12' reflect and transmit solar energy to the right solar cell 30 side, as shown in FIG. 11.

A pair of the channel parts 110 are disposed at the rears of the solar cells 30, such that the channel parts 110 correspond to the solar cells 30, while being parallel to each other. Connections 80a and 80b to connect the channel parts of each photovoltaic-thermal module 10" to the channel parts 10 of the neighboring photovoltaic-thermal modules 10" are provided at corners of each photovoltaic-thermal module 10".

Each channel 110 includes a first opening 111 and a second opening 112, which is located below the first opening 111.

In the same manner as the previous embodiment, a connection member 80 is mounted at the first opening 111 to achieve easy connection between the first opening 111 of each photovoltaic-thermal module 10" and a water supply source or the second opening 112 of the neighboring photovoltaic-thermal module 10".

Consequently, the channel parts of the photovoltaic-thermal modules vertically arranged are connected to one another to form a long straight-line cooling channel in the vertical direction.

In this state, a cooling fluid may flow from the upper end to the lower end of the cooling channel. Of course, it is possible to flow the fluid from the lower end to the upper end of the cooling channel using a drive force of a pump.

Also, the photovoltaic-thermal hybrid apparatus may be rotated by 90 degrees. In this case, the fluid may flow along the cooling channel in the horizontal direction. Consequently, it is possible to change the flow direction of the fluid in the cooling channel based on the disposition of the photovoltaic-thermal hybrid apparatus.

Also, when gas is used as the cooling fluid, the photovoltaic-thermal hybrid apparatus may be installed in a vertical or inclined state such that natural convection occurs from the lower end to the upper end of the cooling channel by a chimney effect.

In this case, a gas introduction port through which external air is introduced may be further provided in the channel to prevent the cooling fluid, i.e., the gas, from overheating.

Since the natural convection effect lowers when the external air is introduced through the gas introduction port, a blowing fan may be installed at the uppermost opening, which serves as the discharge port of the channel.

The heated gas may be stored in a heat storage medium or directly supplied into the room through a vent.

The photovoltaic-thermal hybrid apparatus according to any one of the previous embodiments may be used in a building integrated photovoltaic (BIPV) power generation system which is integrated with an external ornament, such as a wall or a roof, of a building, or of which the installation thickness must be minimized. Unlike the conventional BIPV system, the photovoltaic-thermal hybrid apparatus according to any one of the previous embodiments is also capable of recovering heat. Consequently, the photovoltaic-thermal hybrid apparatus according to any one of the previous embodiments constitutes a combined heat and power (CHP) generation system that is capable of using heat as well as electricity, which is distinguished from the conventional BIPV system. Also, the photovoltaic-thermal hybrid apparatus according to any one of the previous embodiments may be applicable to any fields requiring photovoltaic power generation in addition to the BIPV system.

As is apparent from the above description, it is possible to manufacture the photovoltaic-thermal module to achieve photovoltaic power generation and heat recovery by using the flat panel type condenser and installing the solar cells and the cooling and heat recovery channels at the narrow edges of the condenser. Also, it is possible to manufacture the photovoltaic-thermal hybrid apparatus by integrating a plurality of the photovoltaic-thermal modules using a simple assembly method.

Also, it is possible to manufacture the photovoltaic-thermal hybrid apparatus in a very thin module structure, and therefore, it is possible to minimize the restrictions of an installation place and installation condition which a common large-volume concentration type photovoltaic system suffers.

Also, it is possible to minimize the use of the high-priced solar cells and the installation of the cooling channels by installing the reflection plates at the edges of the condenser, thereby reducing the manufacturing costs and simplifying the manufacturing process.

Although a few embodiments of the present invention have been shown and described, it would be appreciated by those skilled in the art that changes may be made in these embodiments without departing from the principles and spirit of the invention, the scope of which is defined in the claims and their equivalents.

## Claims

1. A photovoltaic-thermal hybrid apparatus comprising a plurality of photovoltaic-thermal modules each comprising at least one condenser, a solar cell disposed at at least one side of the condenser, a frame to surround the condenser and the solar cell, and a channel disposed in the frame to cool the solar cell, wherein the photovoltaic-thermal modules are arranged adjacent to one another, and the channel of each photovoltaic-thermal module is connected to the channel of at least one neighboring photovoltaic-thermal module.

2. The photovoltaic-thermal hybrid apparatus according to claim 1, wherein the frame of each photovoltaic-thermal module is connected to the frames of the neighboring photovoltaic-thermal modules.

3. The photovoltaic-thermal hybrid apparatus according to claim 1 or claim 2, wherein the channel of each photovoltaic-thermal module is directly connected to the channel of at least one neighboring photovoltaic-thermal module.

4. The photovoltaic-thermal hybrid apparatus according to claim 1 or claim 2, further comprising a connection member to connect the channel of each photovoltaic-thermal module to the channel of at least one neighboring photovoltaic-thermal module.

5. The photovoltaic-thermal hybrid apparatus according to any of claim 1 to claim 4, wherein each photovoltaic-thermal module is formed in a rectangular shape, and each photovoltaic-thermal module is provided at at least one corner of the frame thereof with a connection to interconnect the neighboring photovoltaic-thermal modules.

6. The photovoltaic-thermal hybrid apparatus according to claim 5, wherein the connection comprises at least one pair of connections disposed at opposite corners of each photovoltaic-thermal module.

7. The photovoltaic-thermal hybrid apparatus according to claim 6, wherein the channel has first and second openings formed at opposite ends thereof, and the first and second openings are disposed at the connections, respectively.

8. The photovoltaic-thermal hybrid apparatus according to claim 7, wherein the first and/or the second opening is flexible.

9. The photovoltaic-thermal hybrid apparatus according to any of claim 6 to claim 8, wherein the connection comprises an opening and closing part to open and close the connection.

10. The photovoltaic-thermal hybrid apparatus according to claim 9, wherein the opening and closing part comprises an elastic member to provide an elastic force in a direction to close the connection.

11. The photovoltaic-thermal hybrid apparatus according to any of claim 1 to claim 10, wherein the at least one condenser changes a direction of some incident solar energy therein in a radial direction and emits some incident solar energy outside.

12. The photovoltaic-thermal hybrid apparatus according to any of claim 1 to claim 11, further comprising a heat insulation layer disposed in the frame, such that the heat insulation layer surrounds the solar cells and the channel, to prevent the discharge of heat.

13. The photovoltaic-thermal hybrid apparatus according to any of claim 1 to claim 12, further comprising a reflection plate disposed at another side of the condenser to reflect the solar energy to the solar cell.

14. An assembly method of a photovoltaic-thermal hybrid apparatus, comprising: preparing a plurality of photovoltaic-thermal modules each comprising at least one condenser, a solar cell disposed at at least one side of the condenser, a frame to surround the condenser and the solar cell, and a channel disposed in the frame to cool the solar cell;
arranging the photovoltaic-thermal modules adjacent to one another; and
connecting at least one pair of channel parts of the photovoltaic-thermal modules arranged adjacent to one another to form a cooling channel.

15. The assembly method according to claim 14, further comprising preparing a connection member to interconnect the channel parts, wherein the connecting the at least one pair of channel parts comprises connecting ends of the at least one pair of channel parts using the connection member.
